# FASCICULE DE BREVET EUROPEEN

(11) **EP 4 576 457 B1**
(45) Date de publication et mention de la délivrance du brevet: **08.07.2026**
(21) Numéro de dépôt: 24222328.7
(22) Date de dépôt: 20.12.2024
(51) Int. Cl.: H01S 5/227

(54) **COMPOSANT OPTOELECTRONIQUE A RUBAN ENTERRE DANS UNE STRUCTURE SEMI-ISOLANTE**
OPTOELEKTRONISCHES BAUELEMENT MIT VERGRABENEM BAND IN EINER HALBISOLIERENDEN STRUKTUR
OPTOELECTRONIC COMPONENT WITH RIBBON EMBEDDED IN A SEMI-INSULATING STRUCTURE

(30) Priorité: 21.12.2023 FR 2314814
(43) Date de publication de la demande: 25.06.2025
(73) Titulaire: THALES, 92190 Meudon (FR)
(72) Inventeur: CALO, Cosimo, 91767 PALAISEAU (FR); POMMEREAU, Frédéric, 91767 PALAISEAU (FR); ELIAS, Antoine, 91767 PALAISEAU (FR); FORTIN, Catherine, 91767 PALAISEAU (FR)
(74) Mandataire: Atout PI Laplace

(56) Documents cités:
- CN-A- 117 254 348
- JP-B2- H0 728 102
- US-A1- 2004 013 143
- US-A1- 2023 411 931
- SHINODA K ET AL: "LASING OPERATION OF INGAASP-BASED INGAAS/GAAS VERTICAL-CAVITY SURFACE-EMITTING LASERS WITH A STRAIN-COMPENSATED ACTIVE REGION", JAPANESE JOURNAL OF APPLIED PHYSICS, JAPAN SOCIETY OF APPLIED PHYSICS, JP, vol. 35, PART 01, no. 9A, 1 September 1996 (1996-09-01), pages 4660 - 4663, XP000735384, ISSN: 0021-4922, DOI: 10.1143/JJAP.35.4660

## Description

### Champ d'application

L'invention concerne le domaine des dispositifs optoélectroniques actifs à ruban enterré dans une structure semi-isolante. Ce type de composant, qui peut être un laser, un amplificateur, un modulateur ou un détecteur, est par exemple utilisé dans le domaine des télécommunications.

### Problème soulevé

Les composants optoélectroniques à ruban (ou "ridge optoelectronic device" en anglais) sont des composants optiques utilisés dans les dispositifs optoélectroniques tels que les lasers à semi-conducteurs et les amplificateurs optiques. Ces structures se caractérisent par une région active étroite et allongée (typiquement de quelques micromètres de largeur et de plusieurs centaines de micromètres de longueur) entourée de couches de matériaux à plus faible indice de réfraction. Le terme "ridge" fait référence à la forme de la partie supérieure du composant qui est souvent en forme de crête ou ruban. Cette forme permet de confiner la lumière dans une zone restreinte, ce qui est essentiel pour obtenir une émission laser à partir d'un semi-conducteur. Les composants optoélectroniques à ruban sont généralement fabriqués en utilisant des techniques de lithographie et de gravure pour sculpter les couches de semi-conducteurs en forme de crête ou ruban. Des électrodes sont ensuite déposées sur le ruban pour permettre l'injection de courant électrique et l'excitation de la lumière dans la région active. Les composants optoélectroniques à ruban sont largement utilisés dans les dispositifs optiques à semi-conducteurs en raison de leur capacité à produire des faisceaux lumineux étroits et de haute qualité, avec une efficacité élevée et une faible consommation d'énergie.

Un développement plus spécifique est les composants à ruban enterré dans un semi-isolant (traduction de « semi-insulating buried heterostructure (SIBH)» en anglais). La figure 1a illustre une vue partielle d'un composant optoélectronique D0 à ruban enterré dans un semi-isolant selon l'état de l'art. Le composant optoélectronique à ruban D0 est réalisé sur un substrat SUB. Le substrat peut être un substrat massif en un matériau semiconducteur de type III-V ou un empilement de plusieurs matériaux semiconducteurs assemblés. Le composant optoélectronique à ruban D0 comprend une hétérostructure à ruban comprenant une zone active 12' confinée entre une structure de confinement supérieure 13' et une structure de confinement inférieure 11'. La zone active 12' est réalisée par une seule couche ou un empilement de plusieurs couches. Le composant optoélectronique à ruban D0 comprend en outre une première électrode 14' et une seconde électrode 15' réalisées par des couches électriquement conductrices.

Le ruban est enterré de part et d'autre dans la structure semi-isolante 2' selon la direction de guidage Y. Ainsi, la structure à ruban enterré dans une structure semi-isolante consiste en une région active étroite et allongée (comme dans le cas de la structure à ruban classique) qui est enterrée dans une couche de matériau semi-isolant. Le matériau semi-isolant est généralement un matériau semi-conducteur dopé par un métal, par exemple un semi-conducteur III-V dopé avec du fer. Le dopage d'un semi-conducteur par une dose bien déterminée d'ions de métal permet modifier sa structure de bandes d'énergie : la création de nouveaux niveaux d'énergie au milieu de la bande interdite (band gap) qui vont agir comme pièges à électrons : les électrons qui se font capturer par ces pièges et ne participent pas à la conduction de courant et donc au pompage électrique de la zone active. L'avantage de la structure à ruban enterré dans un semi-isolant est qu'elle permet de mieux contrôler la distribution spatiale de la lumière et de limiter les capacités parasites au niveau des interfaces par rapport aux solutions classiques.

Un premier problème technique dans les composants à ruban enterré dans un semi-isolant SIBH consiste aux phénomènes de diffusion des dopants métalliques (les ions de fer par exemple) de la structure semi-isolante vers le ruban enterré ; et inversement la diffusion des dopants P à partir des couches dopées du ruban vers la structure semi-isolante. On parle ainsi d'un phénomène d'inter-diffusion de dopants entre les deux structures. Le phénomène d'inter-diffusion de dopants dans ce cas provoque une dégradation de la performance du composant pour les raisons suivantes : d'une part une détérioration de la résistivité de la structure semi-isolante et d'autre part une augmentation de la résistivité du ruban, plus particulièrement les couches dopés P. Ces effets se traduisent par une augmentation considérable des courants de fuite à travers la diode latérale formée par le ruban dopé P, la structure semi-isolante et la base dopée N. De plus, le phénomène d'inter-diffusion de dopants provoque un échauffement plus important du composant par effet Joule ce qui compromet le fonctionnement optimal du composant.

Un second problème technique a été relevé concernant la non-maitrise de la croissance de la couche semi-conductrice par épitaxie lors de la fabrication des composants à ruban enterré dans un semi-isolant SIBH. Plus particulièrement, le problème est rencontré dans « les composants à ruban désorienté enterré dans un semi-isolant SIBH » (traduction de « tilted semi-insulating buried heterostructure »). Dans ce type de composant, la direction de guidage définie par le ruban présente un angle non-nul (typiquement entre 5° et 10°) par rapport à une direction cristallographique de référence permettant une croissance épitaxie maitrisée selon le substrat choisi. Par exemple, dans le cas d'une croissance d'un matériau semi-isolant en InP dopé Fer à partir d'une couche en InP, la direction cristallographique de référence est la direction donnée par les indices de Miller (011). Si le ruban s'étend parallèlement à la cristallographique de référence, on parle d'un composant à ruban enterré dans un semi-isolant SIBH aligné par rapport à la direction cristallographique du substrat.

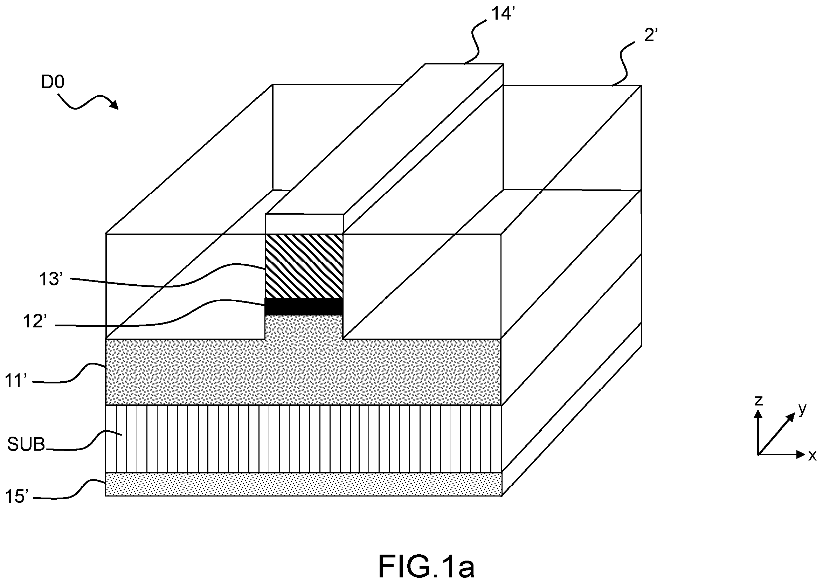

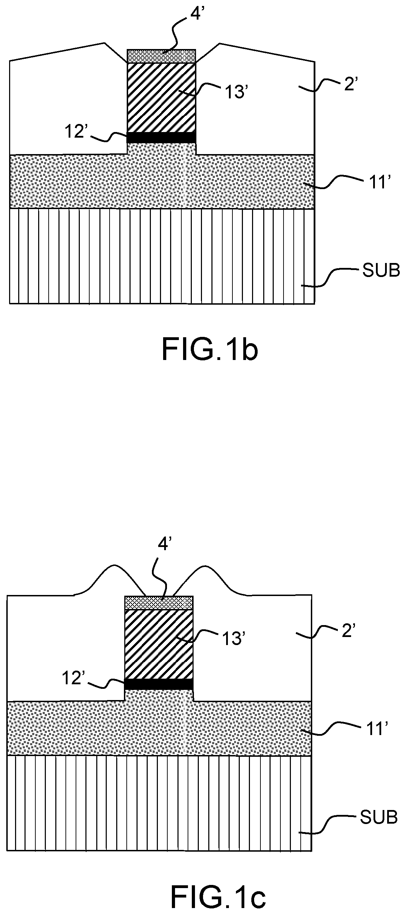

Afin de comprendre le second problème technique, la figure 1b illustre une vue en coupe du résultat de l'étape de croissance de la couche semi-isolante pour un composant à ruban enterré dans un semi-isolant SIBH aligné. La figure 1c illustre une vue en coupe du résultat de l'étape de croissance de la couche semi-isolante pour un composant à ruban désorienté enterré dans un semi-isolant SIBH. Dans le cas du composant à ruban désorienté, la dynamique de croissance de la couche semi-isolante 2' de part et d'autre du ruban de guidage n'est pas maitrisée à cause de la différence de vitesse de croissance entre les plans cristallographiques différents. En effet, lors de la croissance par épitaxie de la couche semi-isolante 2', on observe un débordement de ladite couche semi-isolante 2' pour le composant à ruban désorienté de manière à recouvrir partiellement, et même intégralement, la face supérieure du ruban. La couverture, partielle ou intégrale, de la face supérieure du ruban par la couche semi-isolante constitue un obstacle pour continuer les étapes suivantes du procédé car un accès à cette surface est nécessaire. À titre d'exemple, si la surface supérieure du ruban est couverte par la couche semi-isolante 2', il serait impossible, de réaliser une première électrode 14' supérieure fonctionnelle.

Pour pallier les limitations des solutions existantes, l'invention propose une structure particulière d'un composant optoélectronique à ruban enterré dans une couche semi-isolante. Le composant optoélectronique selon l'invention présente des avantages considérables en termes d'amélioration de dissipation thermique , d'isolation électrique et de limitation des phénomènes d'inter-diffusion des dopants par rapport aux solutions de l'état de l'art.

L'invention concerne en outre un premier procédé de fabrication d'un composant optoélectronique à ruban enterré dans un semi-isolant avec une seule étape de croissance de couche d'enterrement (traduction de One-Step SIBH). Le premier procédé permet de résoudre les problèmes de surcroissance épitaxiale indésirable de la couche semi-isolante préalablement détaillés.

L'invention concerne également un second procédé de fabrication d'un composant optoélectronique à ruban enterré dans un semi-isolant avec deux étapes de croissance de couche d'enterrement (traduction de Two-Step SIBH). Le second procédé permet de résoudre les problèmes de la surcroissance épitaxiale non-maitrisée de la couche semi-isolante ainsi que le phénomène d'inter-diffusion de dopants.

On souligne que le premier procédé et le second procédé sont liés entre eux de sorte à former un seul concept inventif général en vue de résoudre le même problème technique à savoir, la croissance non-maitrisée de la couche semi-isolante qui se développe de manière incontrôlée sur la face supérieure du ruban de guidage ainsi que le phénomène d'inter-diffusion de dopants.

### Résumé /Revendications

L'invention a pour objet un composant optoélectronique comprenant un empilement de couches sur un substrat selon une direction d'empilement ; ledit empilement comprenant :
- une hétérostructure à ruban comprenant une base et un ruban de guidage s'étendant selon une direction de guidage orthogonale à la direction d'empilement , le ruban de guidage étant configuré pour propager une onde lumineuse confinée ; le ruban de guidage ayant une première face latérale et
- une seconde face latérale s'étendant parallèlement à la direction d'empilement et à la direction de guidage ;
- une première couche diélectrique déposée sur la première face latérale ;
- une seconde couche diélectrique déposée sur la seconde face latérale ;
- une structure semi-isolante dans laquelle le ruban de guidage est enterré ;
la première couche diélectrique et la seconde couche diélectrique étant chacune confinée entre la couche semi-isolante et le ruban de guidage.

Selon l'invention, l'épaisseur de la structure semi-isolante est supérieure ou égale à l'épaisseur du ruban de guidage selon la direction d'empilement.

Selon un aspect particulier de l'invention, la première couche diélectrique et la seconde couche diélectrique sont réalisées en un matériau diélectrique incompatible avec le dépôt de la couche semi-isolante par épitaxie.

Selon un aspect particulier de l'invention, la première couche diélectrique et la seconde couche diélectrique sont réalisées en un matériau diélectrique amorphe.

Selon un aspect particulier de l'invention, la première couche diélectrique et la seconde couche diélectrique sont réalisées en oxyde de silicium SiOₓ ou en nitrure de silicium SiNₓ ou en oxy-nitrure de silicium SiOₓN_{y} ou en silicium amorphe dopé avec de l'hydrogène aSi:H ou en un alliage de silicium et de nitrure de silicium ou en oxyde d'aluminium Al₂O₃.

Selon un aspect particulier de l'invention, l'épaisseur de la première couche diélectrique et la seconde couche diélectrique est supérieure ou égale à 5nm.

Selon un aspect particulier de l'invention, la structure semi-isolante est réalisée en un premier matériau semi-conducteur dopé par des ions métalliques.

Selon un aspect particulier de l'invention, l'hétéro-structure à ruban comprend :
- une structure de confinement inférieure réalisée en un deuxième matériau semi-conducteur ;
- une zone active réalisée en au moins un troisième matériau semi-conducteur ;
- une structure de confinement supérieure réalisée en un quatrième matériau semi-conducteur ;

la zone active étant confinée entre la structure de confinement supérieure et la structure de confinement inférieure ; ladite zone active étant conçue pour absorber des photons incidents ou générer des photons par recombinaison de porteurs de charges injectés dans les structures de confinement supérieure et inférieure ;
le ruban de guidage étant formé par au moins : la structure de confinement supérieure et la zone active .

L'invention a également pour objet un procédé de fabrication d'un composant optoélectronique, comprenant les étapes suivantes :
i- fabriquer un ruban intermédiaire en gravant partiellement un empilement initial de couches semi-conductrices déposées sur un substrat ; ledit ruban intermédiaire étant couvert par un masque de gravure en diélectrique ; le ruban intermédiaire étant disposé sur une base intermédiaire formée par les couches non-gravées dudit empilement initial ; ledit ruban intermédiaire s'étendant selon une direction de guidage orthogonale à la direction d'empilement ;
ii- fabriquer une première couche diélectrique déposée sur une première face latérale du ruban intermédiaire et une seconde couche diélectrique déposée sur une seconde face latérale du ruban intermédiaire opposée à ladite première face latérale ;
iii- fabriquer un ruban de guidage par une gravure anisotrope partielle de la base intermédiaire, selon la direction d'empilement , de part et d'autre du ruban intermédiaire ; le ruban de guidage étant disposé sur une base formée par les couches non-gravées dudit empilement initial ; le ruban de guidage et la base formant une hétérostructure à ruban ; ledit ruban de guidage comprenant au moins une zone active destinée à émettre ou absorber des photons ;
iv- déposer par épitaxie au moins une structure électriquement semi-isolante de manière à confiner au moins la zone active dans ladite structure électriquement semi-isolante ;
v- enlever intégralement le masque de gravure en diélectrique par gravure.

Selon un aspect particulier de l'invention, le procédé de fabrication d'un composant optoélectronique comprend en outre l'étape suivante :
vi- enlever intégralement la première couche diélectrique et la seconde couche diélectrique par gravure.

### Description détaillée

D'autres caractéristiques et avantages de la présente invention apparaîtront mieux à la lecture de la description qui suit en relation aux dessins annexés suivants.
[Fig. 1a] la figure 1a illustre une vue partielle d'un composant optoélectronique à ruban selon l'état de l'art. La figure 1a a été déjà décrite.
[Fig. 1b] la figure 1b illustre une vue en coupe du résultat de l'étape de croissance de la couche semi-isolante pour un composant à ruban enterré dans un semi-isolant SIBH aligné selon l'état de l'art. La figure 1b a été déjà décrite.
[Fig. 1c] la figure 1c illustre une vue en coupe du résultat de l'étape de croissance de la couche semi-isolante pour un composant à ruban désorienté enterré dans un semi-isolant SIBH selon l'état de l'art. La figure 1c a été déjà décrite.
[Fig. 2] la figure 2 représente une vue en coupe d'un composant optoélectronique à ruban enterré selon l'invention.
[Fig. 3a] la figure 3a illustre la première étape du premier procédé de fabrication du composant optoélectronique selon l'invention.
[Fig. 3b] la figure 3b illustre la deuxième étape du premier procédé de fabrication du composant optoélectronique selon l'invention.
[Fig. 3c] la figure 3c illustre la troisième étape du premier procédé de fabrication du composant optoélectronique selon l'invention.
[Fig. 3d] la figure 3d illustre la quatrième étape du premier procédé de fabrication du composant optoélectronique selon l'invention.
[Fig. 3e] la figure 3e illustre la cinquième étape du premier procédé de fabrication du composant optoélectronique selon l'invention.
[Fig. 3f] la figure 3f illustre la sixième étape du premier procédé de fabrication du composant optoélectronique selon l'invention.
[Fig. 3g] la figure 3g illustre la septième étape du premier procédé de fabrication du composant optoélectronique selon l'invention.
[Fig. 3h] la figure 3h illustre la huitième étape du premier procédé de fabrication du composant optoélectronique selon l'invention.
[Fig. 4] la figure 4 illustre un organigramme du premier procédé de fabrication du composant optoélectronique selon l'invention.
[Fig. 5] la figure 5 illustre une vue microscopique en coupe d'un composant optoélectronique à ruban enterré selon l'invention en comparaison avec une vue microscopique en coupe d'un composant optoélectronique à ruban enterré selon l'état de l'art.
[Fig. 6a] la figure 6a illustre la première étape du second procédé de fabrication du composant optoélectronique selon l'invention.
[Fig. 6b] la figure 6b illustre la deuxième étape du second procédé de fabrication du composant optoélectronique selon l'invention.
[Fig. 6c] la figure 6c illustre la troisième étape du second procédé de fabrication du composant optoélectronique selon l'invention.
[Fig. 6d] la figure 6d illustre la quatrième étape du second procédé de fabrication du composant optoélectronique selon l'invention.
[Fig. 6e] la figure 6e illustre la cinquième étape du second procédé de fabrication du composant optoélectronique selon l'invention.
[Fig. 6f] la figure 6f illustre la sixième étape du second procédé de fabrication du composant optoélectronique selon l'invention.
[Fig. 6g] la figure 6g illustre la septième étape du second procédé de fabrication du composant optoélectronique selon l'invention.
[Fig. 6h] la figure 6h illustre la huitième étape du second procédé de fabrication du composant optoélectronique selon l'invention.
[Fig. 7] la figure 7 illustre un organigramme du second procédé de fabrication du composant optoélectronique selon l'invention.

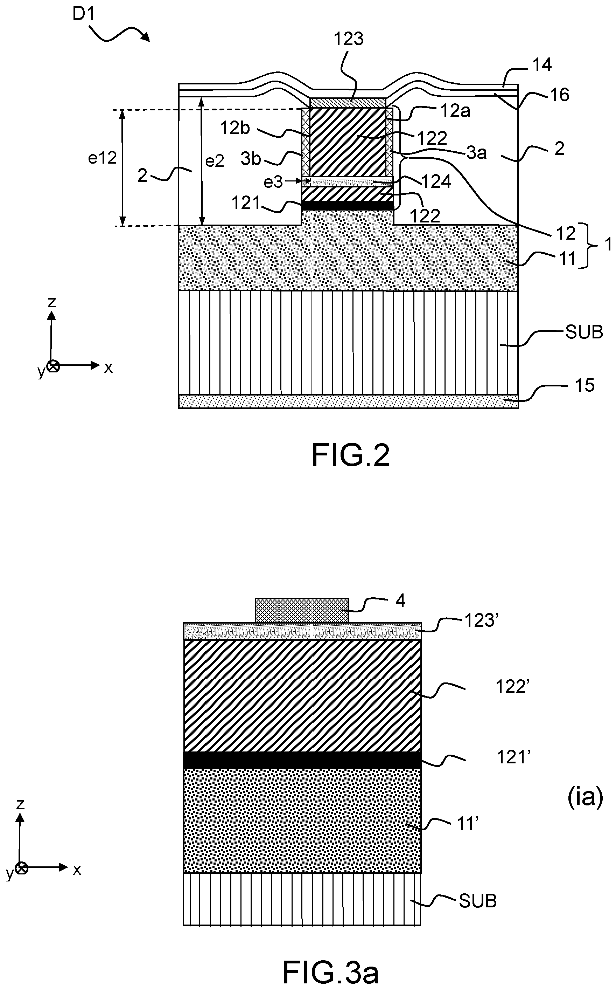

La figure 2 représente une vue en coupe d'un composant optoélectronique D1 selon l'invention, permettant de résoudre les problèmes préalablement décrits.

Le composant optoélectronique D1 comprend un empilement de couches sur un substrat SUB selon une direction d'empilement Z. Le substrat SUB est réalisé par une tranche massive en un matériau semiconducteur de type III-V seule. Alternativement, le substrat SUB est réalisé par une tranche massive en un matériau semiconducteur de type III-V assemblée à un autre substrat en silicium, ou en SOI ou en SiO2 déposée sur silicium. Alternativement, le substrat SUB est réalisé par une couche en un matériau semiconducteur de type III-V déposée sur un autre substrat en silicium, ou en SOI ou en SiO2 déposée sur silicium. À titre d'exemple non limitatif, le matériau semiconducteur de type III-V est le phosphure d'indium InP ou l'arséniure de gallium GaAs.

Ledit empilement de couches comprend une hétérostructure à ruban 1 pour générer et/ou guider une onde électromagnétique, une structure semi-isolante 2 en un premier matériau semi-conducteur dopé avec des ions métalliques, une première électrode 14 et une seconde électrode 15. L'hétérostructure à ruban 1 comprend un ruban de guidage 12 qui s'étend selon une direction de guidage Y et une base 11 sur laquelle repose le ruban 12. Le ruban de guidage 12 est enterré dans la structure semi-isolante 2. On entend par « enterré » une disposition dans laquelle le ruban de guidage 12 est confiné de part et d'autre par rapport à la direction de guidage Y par la structure semi-isolante 2. Le ruban de guidage 12 comprend une première face latérale 12a et une seconde face latérale 12b parallèles. La première face latérale 12a forme un plan parallèle au plan formé par la direction d'empilement Z et à la direction de guidage Y. De même, la seconde face latérale 12b forme un plan parallèle au plan formé par la direction d'empilement Z et à la direction de guidage Y.

Le composant optoélectronique D1 comprend en outre une première couche diélectrique 3a déposée sur la première face latérale 12a et une seconde couche diélectrique 3b déposée sur la seconde face latérale 12b. La structure de confinement inférieure 11 est réalisée par une couche 11 en un matériau semi-conducteur comprenant une protubérance faisant partie du ruban de guidage. La structure de confinement inférieure 11 est dopée N. Alternativement, la structure de confinement inférieure 11 peut être réalisée par un empilement de plusieurs couches semi-conductrices dopées N. Ledit empilement présentant une base et une protubérance faisant partie du ruban de guidage. Dans la suite de l'exposé, nous allons décrire le mode de réalisation où la structure de confinement inférieure 11 est réalisée par une couche 11 à titre d'illustration non limitative et sans exclure une structure de confinement inférieure 11 multicouches.

L'hétérostructure à ruban 1 comprend une zone active 121 confinée entre une structure de confinement supérieure 122 et une structure de confinement inférieure 11. La structure de confinement inférieure 11 comprend au moins une première couche 11 en un deuxième matériau semiconducteur. Avantageusement, le deuxième matériau semiconducteur est de type III-V, à titre d'exemple en InP ou en GaAs. Le deuxième matériau semiconducteur présente une première valeur de gap d'énergie Eg₁. La zone active 121, la structure de confinement supérieure 122 et la protubérance de la structure de confinement inférieure 11 forment ensemble le ruban de guidage 12. La zone active 121 est réalisée en un troisième matériau semiconducteur ayant une deuxième valeur de gap d'énergie Eg₂. Avantageusement, la zone active 121 est réalisée en un alliage ternaire ou quaternaire de type III-V par exemple InGaAsP ou InGaAlAs. Alternativement, la zone active 121 est réalisée par un empilement de couches alternées de différentes compositions d'alliages ternaires ou quaternaires de type III-V. L'épaisseur de chaque couche dudit empilement étant de quelques nm à une dizaine de nm de manière à former une série de puits quantiques (traduction de l'expression anglaise « multi-quantum well layers »).

La structure de confinement supérieure 122 est réalisée par un quatrième matériau semiconducteur ayant une troisième valeur de gap d'énergie Eg₃. Avantageusement, le quatrième matériau semiconducteur est identique au deuxième matériau semiconducteur. Cela permet de faciliter la croissance par épitaxie de l'hétérostructure à ruban. La structure de confinement supérieure 121 est dopée P.

Dans le cas d'une zone active réalisée par une couche massive, la deuxième valeur de gap d'énergie Eg₂ du matériau constituant la zone active 121 est inférieure à la première valeur de gap d'énergie Eg₁ de la structure de confinement inférieure 11. La deuxième valeur de gap d'énergie Eg₂ du matériau constituant la zone active 121 est inférieure à la troisième valeur de gap d'énergie Eg₃ de la structure de confinement supérieure 122.

Dans le cas d'une zone active réalisée par empilement de couches alternées, les matériaux constituant les couches de l'empilement alterné présentent chacune une valeur de gap d'énergie inférieure à la première valeur de gap d'énergie Eg₁ de la structure de confinement inférieure 11.

La première électrode 14 est une microstructure en un matériau conducteur ayant au moins une première partie déposée sur la surface supérieure du ruban de guidage 12 pour créer un chemin électrique entre la première électrode 14 et la structure de confinement supérieure 122. La seconde électrode 15 est une microstructure en un matériau conducteur connectée électriquement à la structure de confinement inférieure 11. La première électrode 14 et la seconde électrode 15 sont destinées à être connectées à un générateur électrique externe non représenté. L'application d'une tension électrique entre les deux électrodes 14 et 15 permet d'injecter des porteurs de charges positives (trous) dans le volume de la structure de confinement supérieure et des porteurs de charges négatives (électrons) dans le volume de la structure de confinement inférieure. Les porteurs de charges de signe opposés se retrouvent confinés dans la zone active 121 à petit gap, pour se recombiner. La recombinaison des électrons et des trous dans la zone active 121 permet l'émission de photons à une longueur d'onde correspondant à la deuxième valeur de gap d'énergie Eg₂. Les photons émis par recombinaison de porteurs de charges injectés sont confinés dans lesdites couches et forment une onde électromagnétique qui se propage selon la direction de guidage Y.

La structure semi-isolante 2 est réalisée par un matériau semi-conducteur dopé par un métal, présentant une bonne conductivité thermique et une bonne isolation électrique. Avantageusement, la structure semi-isolante 2 est réalisée en un semi-conducteur III-V dopé avec du fer, de préférence identique au deuxième matériau semi-conducteur pour faciliter l'épitaxie. La première couche diélectrique 3a et la seconde couche diélectrique 3b sont chacune confinée latéralement entre la couche semi-isolante 2 et le ruban de guidage 12. Les deux couches diélectriques 3a,3b permettent d'éliminer le phénomène d'inter-diffusion de dopants entre la structure de confinement supérieure 122 et la structure semi-isolante 2. L'élimination du phénomène d'inter-diffusion des dopants permet de préserver l'aspect semi-isolant de la structure semi-isolante 2 et de préserver la conductivité de la structure de confinement supérieure 122. Cela permet de réduire les courants de fuites latérales dans le composant optoélectronique D1 et ainsi améliorer la performance globale du composant. Un avantage supplémentaire de l'insertion des couches diélectriques 3a,3b consiste en la réduction de l'échauffement par effet Joule du composant lors de son fonctionnement grâce à la réduction de la résistivité de la structure de confinement supérieure 122.

Avantageusement, l'épaisseur latérale e3 de chacune des couches diélectriques de séparation 3a,3b est supérieure ou égale à 5nm de manière à assurer une bonne isolation face à la diffusion des dopants.

A titre d'exemple illustratif et non limitatif, les deux couches diélectriques de séparation 3a,3b sont réalisées par un matériau diélectrique incompatible avec le dépôt latéral de la couche semi-isolante 2 par épitaxie. Cela permet d'avoir un procédé maitrisé de croissance par épitaxie de la structure semi-isolante 2, et plus particulièrement d'éviter le phénomène de surcroissances indésirables de la structure semi-isolante 2 décrit dans la figure 1c. L'incompatibilité de croissance est déterminée par au moins la propriété suivante du matériau diélectrique des couches de séparation 3a, 3b: les réactions chimiques entre le diélectrique utilisé pour les couches de séparation 3a,3b et le matériau semi-isolant 2 épitaxié ne permettent pas la formation d'une couche adhérente au niveau des interfaces.

Avantageusement, la première couche diélectrique 3a et la seconde couche diélectrique 3b sont réalisées en un matériau diélectrique amorphe afin d'assurer ladite incompatibilité de croissance. À titre d'exemple illustratif et non limitatif, la première couche diélectrique 3a et la seconde couche diélectrique 3b sont réalisées en oxyde de silicium SiOₓ ou en nitrure de silicium SiNₓ ou en oxy-nitrure de silicium SiOₓN_{y} ou en silicium amorphe hydrogéné aSi:H ou en un alliage de silicium et de nitrure de silicium (appelé SRN) ou en oxyde d'aluminium Al₂O₃.

De manière plus avantageuse, la première couche diélectrique 3a et la seconde couche diélectrique 3b sont réalisées en l'alliage de silicium et de nitrure de silicium SRN qui présente une stœchiométrie intermédiaire entre le nitrure de silicium SiNₓ et silicium amorphe hydrogéné aSi:H. L'alliage de silicium et de nitrure de silicium SRN présente un indice de réfraction modulable compris entre 2 et 3,45 à une longueur d'onde de 1,55µm. Cela permet de réaliser des couches de séparation diélectriques 3a, 3b présentant les avantages préalablement cités sans aucune perturbation optique des modes de propagation dans le ruban de guidage et indépendamment de l'épaisseur latérale e3 de la première couche diélectrique 3a et la seconde couche diélectrique 3b. Il est ainsi possible avec l'alliage SRN d'augmenter l'épaisseur afin d'assurer un meilleur contrôle de la fabrication.

Avantageusement, l'épaisseur e2 la structure semi-isolante 2 est supérieure ou égale à l'épaisseur e12 du ruban de guidage 12. Cela permet de maximiser le volume de la structure semi-isolante 2 de manière à améliorer la dissipation thermique à travers ladite structure semi-isolante 2. Dans les solutions de l'état de l'art, cette maximisation n'est pas envisageable à cause de la dégradation de performance du composant induite par les phénomènes d'inter-diffusion.

Optionnellement, la structure de confinement supérieure 122 comprend une couche d'arrêt de gravure 124 pour protéger la zone active 121. À titre d'exemple, lorsque le ruban de guidage 12 est formé par le phosphure d'indium InP, la couche d'arrêt de gravure 124 est réalisée par l'alliage GalnAsP pour permettre une gravure sélective de l'InP afin de fabriquer l'hétérostructure à ruban 1. À titre d'exemple, lorsque le ruban de guidage 12 est formé par l'arséniure de gallium GaAs, la couche d'arrêt de gravure 124 est réalisée par l'alliage GalnP pour permettre une gravure sélective du GaAs afin de fabriquer l'hétérostructure à ruban 1. L'épaisseur de la couche d'arrêt de gravure doit être inférieure à 20nm, de préférence égale à 10nm, pour ne pas engendrer une perturbation optique de l'onde électromagnétique guidée par le ruban de guidage 12.

Le composant optoélectronique D1 comprend en outre une couche de contact ohmique 123 confinée entre la surface supérieure du ruban de guidage 12 et la première électrode 14. Par exemple, la couche de contact ohmique 123 est réalisée par le cinquième matériau semi-conducteur dopé P avec une concentration de dopants supérieure à celle de la structure de confinement supérieure 122.

Les figures 3a à 3h illustrent les étapes d'un premier procédé P1 de fabrication du composant optoélectronique D1 selon l'invention.

La première étape ia) illustrée par la figure 3a consiste à fournir ou fabriquer sur le substrat SUB décrit précédemment un empilement de couches selon la direction d'empilement Z comprenant en partant dudit substrat :
- une première couche 11' réalisé par un matériau semiconducteur dopé N.
- une deuxième couche 121' réalisé par un matériau semiconducteur ayant un gap d'énergie inférieur à celui de la première couche 11'. La deuxième couche 121' est destinée à former la zone active 121. Alternativement, la deuxième couche 121' est remplacée par un empilement de couches alternées de différentes compositions d'alliages ternaires ou quaternaires de type III-V. Les matériaux constituant les couches d'empilement alterné présentent chacune une valeur de gap d'énergie inférieure à celui de la première couche 11'. L'empilement alterné est destiné à former la zone active 121'. Dans la suite, nous allons décrire le mode de réalisation avec une zone active réalisée par la deuxième couche 121'. Les étapes du procédé sont compatibles avec une zone active 121 réalisée en une couche massive 121' ou un empilement de couches alternées.
- au moins une troisième couche 122' réalisée par un matériau semiconducteur dopé P. La troisième couche 122' destinée à faire partie de la structure de confinement supérieure 122.
- une couche de contact électrique 123' en un semi-conducteur dopé P⁺.
- un masque de gravure 4 en diélectrique définissant la zone correspondant à la largeur et à la longueur du ruban de guidage à fabriquer ultérieurement.

Selon un premier exemple, la première couche 11' est en InP dopé N avec une épaisseur de 0.5µm à 5µm, la deuxième couche 121' est en un alliage ternaire ou quaternaire de l'Indium intrinsèque avec une épaisseur de 100nm à 400nm, la troisième couche 122' est en InP dopé P avec une épaisseur de 1µm à 3µm, la couche de contact ohmique 123' est en InP dopé P⁺ avec une épaisseur de 100nm à 300nm, le masque de gravure 4 est en oxyde de silicium SiOₓ.

L'étape ia) est réalisable par la croissance de couches minces par épitaxie ou par dépôt par pulvérisation.

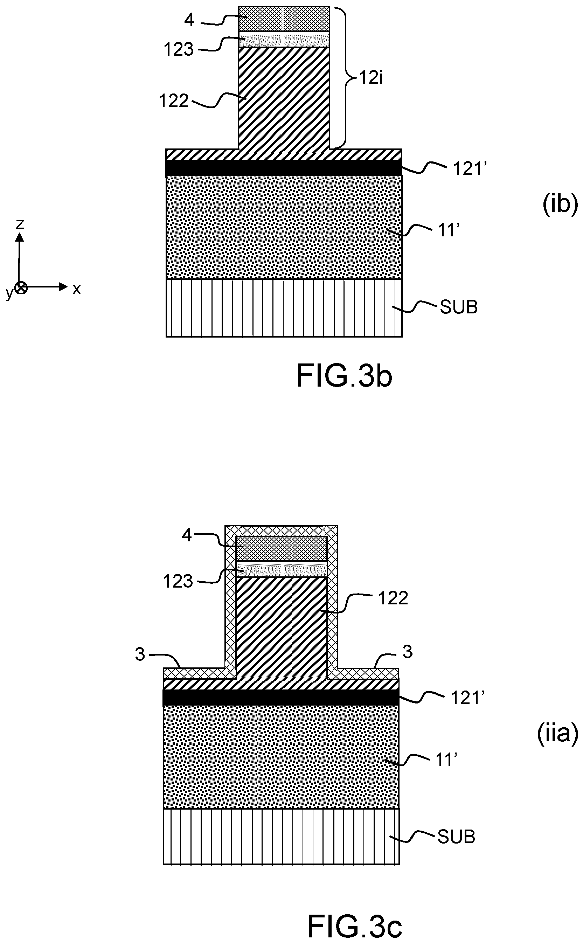

L'étape suivante ib), illustrée par la figure 3b, consiste à fabriquer un ruban intermédiaire 12i en gravant partiellement l'empilement initial de couches semi-conductrices et plus particulièrement la troisième couche 122' et la couche de contact électrique 123'. On obtient un ruban intermédiaire couvert par le masque de gravure en diélectrique 4. Le ruban intermédiaire 12i est disposé sur une base intermédiaire formée par les couches non-gravées 121',11' dudit empilement initial. Ledit ruban intermédiaire s'étendant selon une direction de guidage (Y) orthogonale à la direction d'empilement (Z). Cette étape est réalisée par gravure sèche physique ou gravure chimique humide.

L'étape suivante iia), illustrée par la figure 3c, consiste à déposer sur toute la structure intermédiaire obtenue dans l'étape précédente une couche en diélectrique 3. La couche en diélectrique couvre toutes les parois externes de la structure intermédiaire obtenue dans l'étape précédente. L'épaisseur de la couche en diélectrique 3 est supérieure ou égale à 5nm, afin de tenir en compte des gravures potentielles indésirables dans la suite du procédé. Le matériau de la couche diélectrique 3 est choisi de sorte à respecter les critères suivants :
- La possibilité de graver sélectivement la couche diélectrique 3 par rapport au masque de gravure 4.
- La possibilité de graver sélectivement le masque - par rapport à la couche diélectrique 3.
- Avantageusement, l'incompatibilité de la couche diélectrique 3 avec une accroche de la couche semi-isolante épitaxiée ultérieurement.

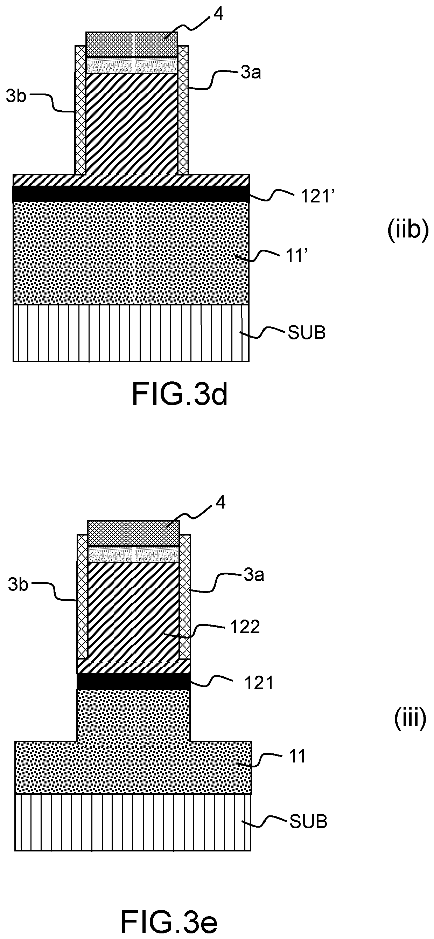

L'étape suivante iib), illustrée par la figure 3d, consiste à fabriquer une première couche diélectrique 3a déposée sur une première face latérale 12a du ruban intermédiaire 12i et une seconde couche diélectrique 3b déposée sur une seconde face latérale 12b du ruban intermédiaire 12i opposée à ladite première face latérale 12a. Cette étape est réalisée par une gravure anisotrope sans masque de la couche diélectrique 3.

A titre d'exemples non limitatifs, on définit les couples suivants pour les choix de matériaux du masque de gravure 4 et de la couche diélectrique 3 : pour un masque de gravure 4 en oxyde de silicium SiOₓ, la couche diélectrique 3 est réalisée en nitrure de silicium SiNₓ ou en silicium amorphe hydrogéné aSi:H ou en un alliage de silicium et de nitrure de silicium SRN. Il est possible de graver sélectivement les matériaux SiNₓ, aSi:H et SRN par rapport à l'oxyde de silicium SiOₓ à travers des processus de gravure ionique réactive à base de SF₆ ou XeF₂ . Suite à cette étape de gravure, l'épaisseur des couches de diélectriques 3a,3b est supérieure ou égale à 5nm.

L'étape suivante iii), illustrée par la figure 3e, consiste à fabriquer un ruban de guidage 12 par une gravure anisotrope partielle de la base intermédiaire, selon la direction d'empilement Z. La gravure est réalisée de part et d'autre du ruban intermédiaire 12i à travers les couches 11', 121' et 122. On obtient ainsi la forme finale du ruban de guidage 12 surmonté par le masque de gravure 4.

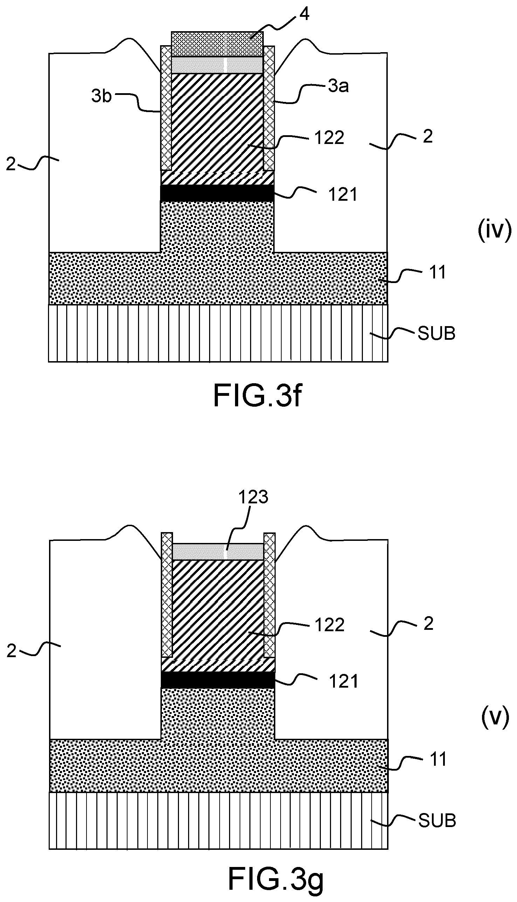

L'étape suivante iv), illustrée par la figure 3f, consiste à déposer par épitaxie une structure électriquement semi-isolante 2 de manière à confiner le ruban de guidage 12 dans ladite structure électriquement semi-isolante 2. La première couche diélectrique 3a et la seconde couche diélectrique 3b sont chacune confinée entre la couche semi-isolante 2 et le ruban de guidage 12. Les deux couches diélectriques de séparation 3a,3b sont réalisées par un matériau diélectrique incompatible avec le dépôt latéral de la couche semi-isolante 2 par épitaxie. Cela permet d'avoir un procédé maitrisé de croissance par épitaxie de la structure semi-isolante 2, et plus particulièrement d'éviter le phénomène de débordement de la structure semi-isolante 2 même pour le cas « des composants à ruban désorienté enterré dans un semi-isolant SIBH ». (traduction de « tilted semi-insulating buried heterostructure »). Le procédé selon l'invention permet ainsi de s'affranchir de la contrainte de débordement ou de surcroissances indésirables de la structure semi-isolante indépendamment de la direction de guidage du ruban. Cela offre un avantage considérable consistant en la possibilité de fabriquer des composants à ruban enterré dans un semi-isolant avec plusieurs directions sur le même substrat et avec le même procédé de fabrication. La possibilité de fabriquer en même temps des rubans alignés et désorientés avec la même qualité ouvre des possibilités de conception de systèmes optoélectroniques non explorées.

L'étape suivante v), illustrée par la figure 3g, consiste à enlever intégralement le masque de gravure en diélectrique 4 par gravure sélective par rapport aux couches diélectriques de séparation 3a,3b. Pour un masque de gravure 4 en oxyde de silicium SiOₓ, la couche diélectrique 3 est réalisée en nitrure de silicium SiNₓ ou en silicium amorphe dopé avec de l'hydrogène aSi:H ou en un alliage de silicium et de nitrure de silicium SRN. Il est possible de graver sélectivement l'oxyde de silicium SiOₓ par rapport aux SiNₓ , aSi:H et SRN avec une solution tampon pour la gravure d'oxyde comprenant de l'acide fluorhydrique HF par exemple.

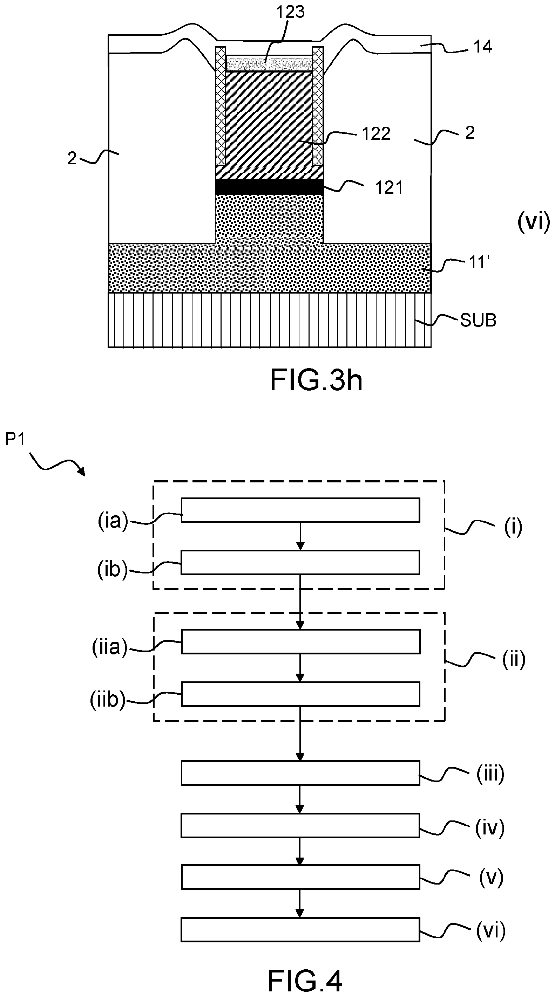

L'étape suivante vi), illustrée par la figure 3h, consiste à déposer une première électrode 14 et une seconde électrode 15 telles que décrites précédemment.

La figure 4 illustre un organigramme du premier procédé de fabrication du composant optoélectronique selon l'invention.

La première étape i) consiste à fournir ou fabriquer un ruban intermédiaire 12i en gravant partiellement un empilement initial de couches semi-conductrices déposées sur un substrat. L'étape i) comprend les étapes ia) et ib) décrites précédemment. La deuxième étape ii) consiste à fabriquer la première couche diélectrique 3a déposée sur une première face latérale 12a du ruban intermédiaire et la seconde couche diélectrique 3b déposée sur une seconde face latérale 12b du ruban intermédiaire 12i opposée à ladite première face latérale 12a. L'étape ii) comprend les étapes iia) et iib) décrites précédemment. Les étapes restantes iii) à vi) ont été décrites précédemment.

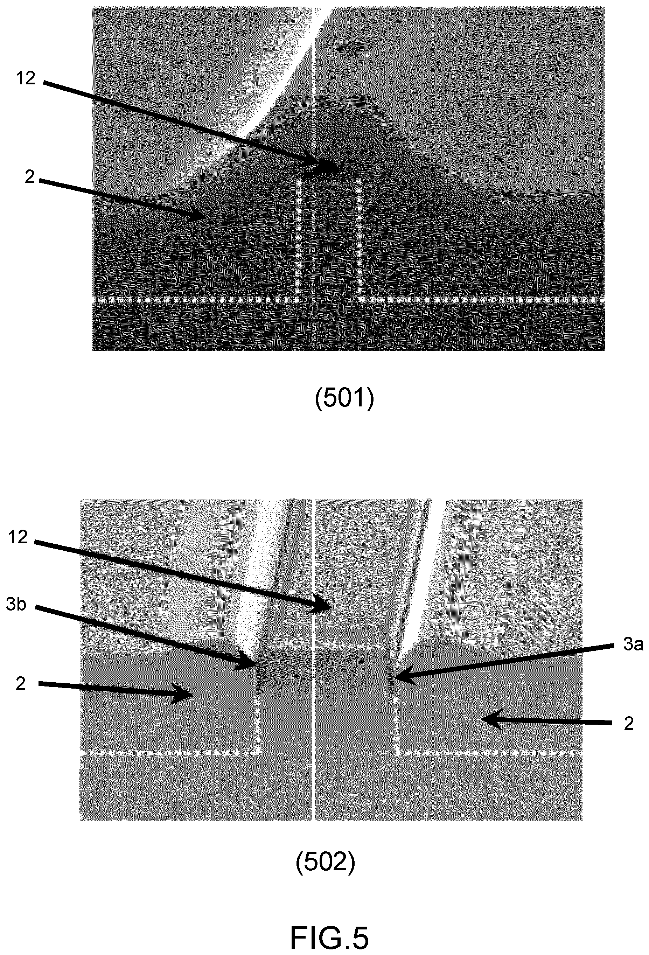

La figure 5 illustre une vue microscopique en coupe (502) d'un composant optoélectronique à ruban enterré D1 selon l'invention en comparaison avec une vue microscopique (501) en coupe d'un composant D0 optoélectronique à ruban enterré selon l'état de l'art. On observe le phénomène de surcroissance indésirable de la structure semi-isolante 2 sur le ruban de guidage 12 dans le composant à ruban désorienté selon l'état de l'art. Dans la vue microscopique en coupe (502) d'un composant obtenu par le procédé selon l'invention, le problème de débordement de la structure semi-isolante 2 sur le ruban de guidage 12 a été résolu.

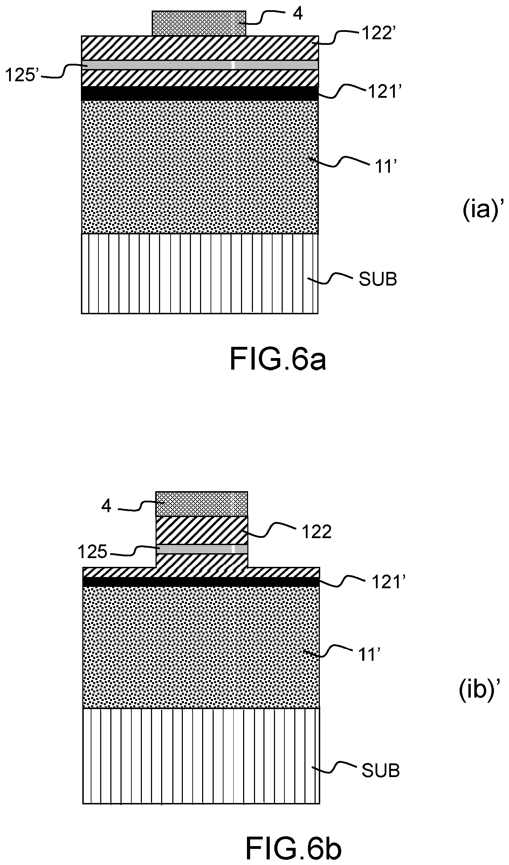

Les figures 6a à 6h illustrent les étapes d'un second procédé P2 de fabrication du composant optoélectronique D2. L'invention concerne également le second procédé de fabrication P2 d'un composant optoélectronique à ruban enterré dans un semi-isolant avec deux étapes de croissance de couche d'enterrement (traduction de Two-Step SIBH). Le second procédé P2 permet de résoudre les problèmes de surcroissance et de croissance épitaxiale non-maitrisée de la couche semi-isolante préalablement détaillés.

De plus, le problème d'inter-diffusion des dopants entre la couche semi-isolante et le ruban est aussi présent dans les dispositifs de type Two-Step SIBH. Plus particulièrement, le problème d'inter-diffusion est accentué lors de l'étape de croissance par épitaxie de la structure semi-isolante à haute température (de l'ordre de 700°C). Les phénomènes d'inter-diffusion de dopants induisent une augmentation des courants de fuite dans les composants de type Two-Step SIBH de manière similaire aux composants de type One-step SIBH.

On souligne que le premier procédé P1 et le second procédé P2 sont liés entre eux de sorte à former un seul concept inventif général en vue de résoudre le même problème technique à savoir, l'utilisation de couches diélectriques latérales d'isolation avant la reprise par épitaxie pour résoudre le problème de croissance non-maitrisée de la couche semi-isolante qui se développe de manière incontrôlée sur la face supérieure du ruban de guidage ainsi que le problème de l'interdiffusion des dopants p.

La première étape ia)', illustrée par la figure 6a, est identique à l'étape ia)' du premier procédé P1. De manière optionnelle, l'empilement représenté pour l'illustration du deuxième procédé P2 comprend une couche pour la fabrication de réseau de diffraction 125' (traduction de diffraction grating layer) insérée dans la troisième couche 122'.

L'étape suivante ib)' du deuxième procédé P2, illustrée par la figure 6b, est similaire à l'étape ib) du premier procédé P1.

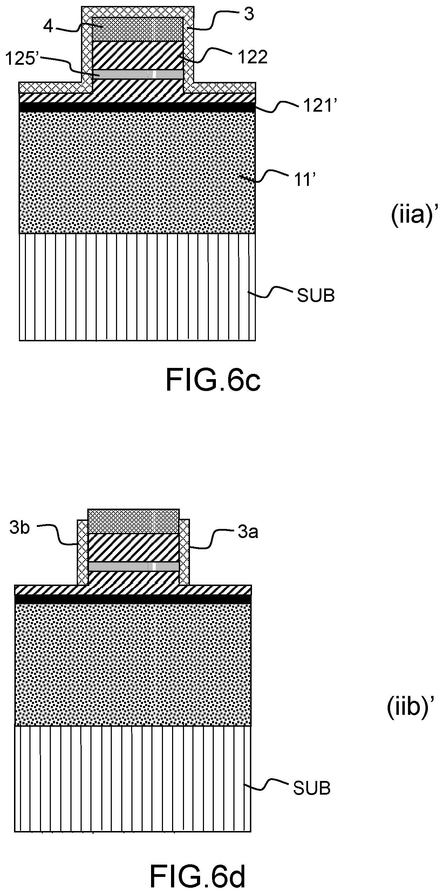

L'étape suivante iia)' du deuxième procédé P2, illustrée par la figure 6c, est similaire à l'étape iia) du premier procédé P1.

L'étape suivante iib)' du deuxième procédé P2, illustrée par la figure 6d, est similaire à l'étape iib) du premier procédé P1.

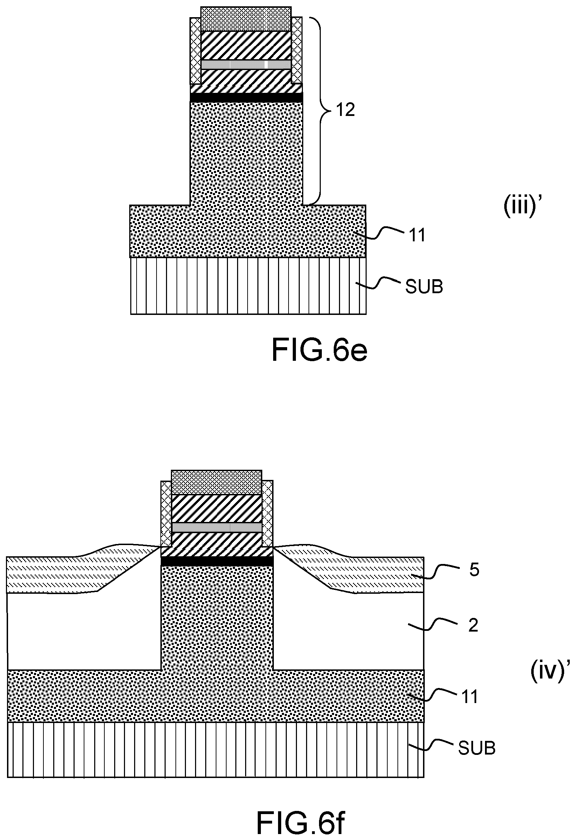

L'étape suivante iii)' du deuxième procédé P2, illustrée par la figure 6e, est similaire à l'étape iii) du premier procédé P1.

L'étape suivante iv)' du deuxième procédé P2, illustrée par la figure 6f, consiste à déposer par épitaxie une structure électriquement semi-isolante 2 et une couche de blocage de diffusion 5 de manière à confiner au moins la structure de confinement inférieure 11 et la zone active 121 dans l'empilement formé par les couches 2 et 5. Par exemple, la structure électriquement semi-isolante 2 est une couche semi-isolante en InP dopé fer et la couche de blocage de diffusion 5 est une couche en InP dopé par du ruthénium ou dopé N.

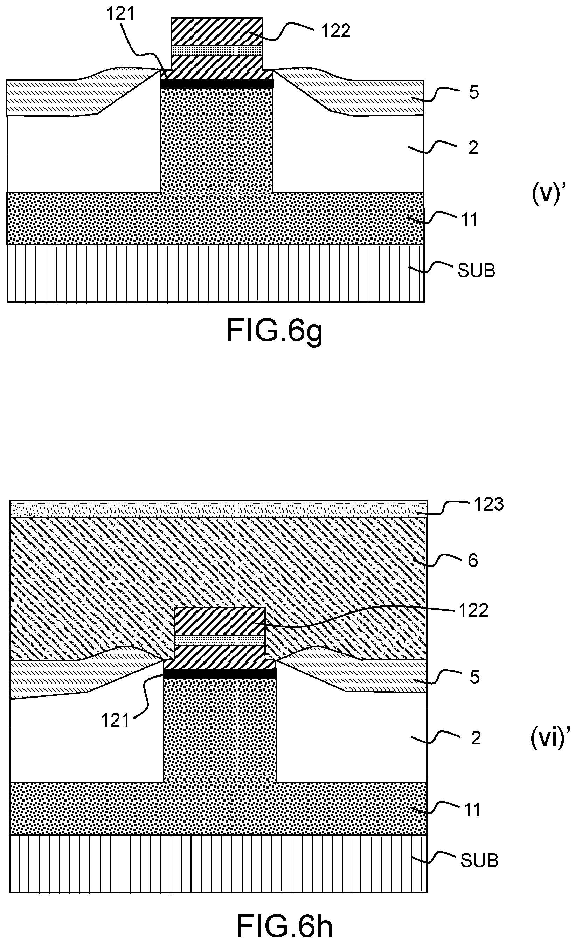

L'étape suivante v)' du deuxième procédé P2, illustrée par la figure 6g, consiste à enlever intégralement par gravure la première couche en diélectrique 3a, la seconde couche en diélectrique 3b et le masque de gravure 4. Cette étape peut être réalisée par deux opérations de gravures sélectives séparées ou par une opération de gravure non sélective, typiquement une gravure chimique à base de Fluorure d'hydrogène HF.

L'étape suivante vi)' du deuxième procédé P2, illustrée par la figure 6h, consiste à faire croitre par épitaxie une couche de gaine 6 réalisée en un semi-conducteur dopé P. La couche de gaine 6 encapsule la partie apparente du ruban de guidage 12. L'étape vi)' comprend en outre le dépôt d'une couche contact électrique 123 sur la surface supérieure de la couche de gaine 6.

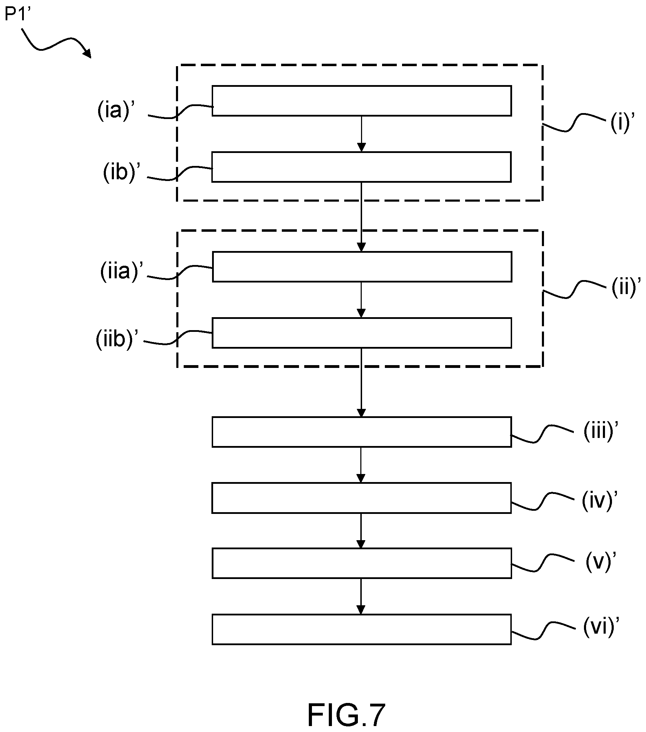

La figure 7 illustre un organigramme du second procédé de fabrication P2 selon l'invention. La première étape i)' consiste à fournir ou fabriquer un ruban intermédiaire 12i en gravant partiellement un empilement initial de couches semi-conductrices déposées sur un substrat. L'étape i)' comprend les étapes ia)' et ib)' décrites précédemment. La deuxième étape ii)' consiste à fabriquer la première couche diélectrique 3a déposée sur une première face latérale 12a du ruban intermédiaire et la seconde couche diélectrique 3b déposée sur une seconde face latérale 12b du ruban intermédiaire 12i opposée à ladite première face latérale 12a. L'étape ii)' comprend les étapes iia)' et iib)' décrites précédemment. Les étapes restantes iii)' à vi)' ont été décrites précédemment.

## Revendications

1. Composant optoélectronique (D1) comprenant un empilement de couches sur un substrat (SUB) selon une direction d'empilement (Z) ; ledit empilement comprenant :
- une hétérostructure à ruban (1) comprenant une base (11) et un ruban de guidage (12) s'étendant selon une direction de guidage (Y) orthogonale à la direction d'empilement (Z) , le ruban de guidage (12) étant configuré pour propager une onde lumineuse confinée ; le ruban de guidage (12) ayant une première face latérale (12a) et une seconde face latérale (12b) s'étendant parallèlement à la direction d'empilement (Z) et à la direction de guidage (Y) ;
- une première couche diélectrique (3a) déposée sur la première face latérale (12a) ;
- une seconde couche diélectrique (3b) déposée sur la seconde face latérale (12b) ;
- une structure semi-isolante (2) dans laquelle le ruban de guidage (12) est enterré ;
la première couche diélectrique (3a) et la seconde couche diélectrique (3b) étant chacune confinée entre la couche semi-isolante (2) et le ruban de guidage (12) ;
**caractérisé en ce que** l'épaisseur (e2) de la structure semi-isolante (2) étant supérieure ou égale à l'épaisseur (e12) du ruban de guidage (12) selon la direction d'empilement (Z),

2. Composant optoélectronique (D1) selon la revendication 1 dans lequel la première couche diélectrique (3a) et la seconde couche diélectrique (3b) sont réalisées en un matériau diélectrique incompatible avec le dépôt de la couche semi-isolante (2) par épitaxie.

3. Composant optoélectronique (D1) selon l'une des revendications 1 ou 2 dans lequel la première couche diélectrique (3a) et la seconde couche diélectrique (3b) sont réalisées en un matériau diélectrique amorphe.

4. Composant optoélectronique (D1) selon l'une des revendications 1 à 3 dans lequel la première couche diélectrique (3a) et la seconde couche diélectrique (3b) sont réalisées en oxyde de silicium SiOₓ ou en nitrure de silicium SiNₓ ou en oxy-nitrure de silicium SiOₓN_{y} ou en silicium amorphe dopé avec de l'hydrogène aSi:H ou en un alliage de silicium et de nitrure de silicium ou en oxyde d'aluminium Al₂O₃.

5. Composant optoélectronique (D1) selon l'une des revendications 1 à 4 dans lequel l'épaisseur (e3) de la première couche diélectrique (3a) et la seconde couche diélectrique (3b) est supérieure ou égale à 5nm.

6. Composant optoélectronique (D1) selon l'une des revendications 1 à 5 dans lequel la structure semi-isolante (2) est réalisée en un premier matériau semi-conducteur dopé par des ions métalliques.

7. Composant optoélectronique (D1) selon l'une des revendications 1 à 6 dans lequel l'hétéro-structure à ruban (1) comprend :
• une structure de confinement inférieure (11) réalisée en un deuxième matériau semi-conducteur ;
• une zone active (121) réalisée en au moins un troisième matériau semi-conducteur ;
• une structure de confinement supérieure (122) réalisée en un quatrième matériau semi-conducteur ;
la zone active étant confinée entre la structure de confinement supérieure (122) et la structure de confinement inférieure (11) ; ladite zone active étant conçue pour absorber des photons incidents ou générer des photons par recombinaison de porteurs de charges injectés dans les structures de confinement supérieure (122) et inférieure (11) ;
le ruban de guidage (12) étant formé par au moins : la structure de confinement supérieure et la zone active (121).

8. Procédé de fabrication d'un composant optoélectronique (D1, D2), comprenant les étapes suivantes :
i- fabriquer un ruban intermédiaire (12i) en gravant partiellement un empilement initial de couches semi-conductrices (11', 121', 122') déposées sur un substrat (SUB); ledit ruban intermédiaire étant couvert par un masque de gravure en diélectrique (4) ; le ruban intermédiaire (12i) étant disposé sur une base intermédiaire formée par les couches non-gravées dudit empilement initial (121', 11') ; ledit ruban intermédiaire s'étendant selon une direction de guidage (Y) orthogonale à la direction d'empilement (Z) ;
ii- fabriquer une première couche diélectrique (3a) déposée sur une première face latérale (12a) du ruban intermédiaire et une seconde couche diélectrique (3b) déposée sur une seconde face latérale (12b) du ruban intermédiaire (12i) opposée à ladite première face latérale (12a) ;
iii- fabriquer un ruban de guidage (12) par une gravure anisotrope partielle de la base intermédiaire, selon la direction d'empilement (Z), de part et d'autre du ruban intermédiaire (12i) ; le ruban de guidage (12) étant disposé sur une base (11) formée par les couches non-gravées dudit empilement initial ; le ruban de guidage (12) et la base (11) formant une hétérostructure à ruban (1) ; ledit ruban de guidage (12) étant configuré pour propager une onde lumineuse confinée
iv- déposer par épitaxie au moins une structure électriquement semi-isolante (2) de manière à confiner le ruban de guidage (12) dans ladite structure électriquement semi-isolante (2) ; la première couche diélectrique (3a) et la seconde couche diélectrique (3b) étant chacune confinée entre la couche semi-isolante (2) et le ruban de guidage (12) ;
v- enlever intégralement le masque de gravure en diélectrique (4) par gravure.

## Patentansprüche

1. Optoelektronisches Bauelement (D1), das einen Stapel von Schichten auf einem Substrat (SUB) in einer Stapelrichtung (Z) umfasst; wobei der Stapel umfasst:
- eine Band-Heterostruktur (1), umfassend eine Basis (11) und ein Führungsband (12), das sich in einer Führungsrichtung (Y) orthogonal zur Stapelrichtung (Z) erstreckt, wobei das Führungsband (12) konfiguriert ist, um eine begrenzte Lichtwelle auszubreiten; wobei das Führungsband (12) eine erste Seitenfläche (12a) und eine zweite Seitenfläche (12b) aufweist, die sich parallel zur Stapelrichtung (Z) und zur Führungsrichtung (Y) erstrecken;
- eine erste dielektrische Schicht (3a), die auf der ersten Seitenfläche (12a) aufgebracht ist;
- eine zweite dielektrische Schicht (3b), die auf der zweiten Seitenfläche (12b) aufgebracht ist;
- eine halbisolierende Struktur (2), in der das Führungsband (12) eingegraben ist;
wobei die erste dielektrische Schicht (3a) und die zweite dielektrische Schicht (3b) jeweils zwischen der halbisolierenden Schicht (2) und dem Führungsband (12) begrenzt sind;
**dadurch gekennzeichnet, dass**
die Dicke (e2) der halbisolierenden Struktur (2) in der Stapelrichtung (Z) größer oder gleich der Dicke (e12) des Führungsbandes (12) ist.

2. Optoelektronisches Bauelement (D1) nach Anspruch 1, wobei die erste dielektrische Schicht (3a) und die zweite dielektrische Schicht (3b) aus einem dielektrischen Material ausgeführt sind, das mit der Abscheidung der halbisolierenden Schicht (2) durch Epitaxie nicht kompatibel ist.

3. Optoelektronisches Bauelement (D1) nach einem der Ansprüche 1 oder 2, wobei die erste dielektrische Schicht (3a) und die zweite dielektrische Schicht (3b) aus einem amorphen dielektrischen Material ausgeführt sind.

4. Optoelektronisches Bauelement (D1) nach einem der Ansprüche 1 bis 3, wobei die erste dielektrische Schicht (3a) und die zweite dielektrische Schicht (3b) aus Siliziumoxid SiOₓ oder aus Siliziumnitrid SiNₓ oder aus Siliziumoxynitrid SioₓN_{y} oder aus mit Wasserstoff dotiertem amorphem Silizium aSi:H oder aus einer Legierung aus Silizium und Siliziumnitrid oder aus Aluminiumoxid Al₂O₃ ausgeführt sind.

5. Optoelektronisches Bauelement (D1) nach einem der Ansprüche 1 bis 4, wobei die Dicke (e3) der ersten dielektrischen Schicht (3a) und der zweiten dielektrischen Schicht (3b) größer oder gleich 5 nm ist.

6. Optoelektronisches Bauelement (D1) nach einem der Ansprüche 1 bis 5, wobei die halbisolierende Struktur (2) aus einem ersten, mit Metallionen dotierten Halbleitermaterial ausgeführt ist.

7. Optoelektronisches Bauelement (D1) nach einem der Ansprüche 1 bis 6, wobei die Band-Heterostruktur (1) umfasst:
- eine untere Begrenzungsstruktur (11), die aus einem zweiten Halbleitermaterial ausgeführt ist;
- eine aktive Zone (121), die aus mindestens einem dritten Halbleitermaterial ausgeführt ist;
- eine obere Begrenzungsstruktur (122), die aus einem vierten Halbleitermaterial ausgeführt ist;
wobei die aktive Zone zwischen der oberen Begrenzungsstruktur (122) und der unteren Begrenzungsstruktur (11) begrenzt ist; wobei die aktive Zone dazu gestaltet ist, um Photonen durch Rekombination von in die obere (122) und untere Begrenzungsstruktur (11) injizierten Ladungsträgern zu erzeugen;
wobei das Führungsband (12) ausgebildet ist aus mindestens: der oberen Begrenzungsstruktur und der aktiven Zone (121).

8. Verfahren zum Herstellen eines optoelektronischen Bauelements (D1, D2), das die folgenden Schritte umfasst:
i- Herstellen eines Zwischenbandes (12i) durch teilweises Ätzen eines ursprünglichen Stapels von Halbleiterschichten (11', 121', 122'), die auf einem Substrat (SUB) aufgebracht sind; wobei das Zwischenband von einer dielektrischen Ätzmaske (4) bedeckt ist; wobei das Zwischenband (12i) auf einer Zwischenbasis angeordnet ist, die durch die nicht geätzten Schichten des ursprünglichen Stapels (121', 11') gebildet wird; wobei sich das Zwischenband in einer Führungsrichtung (Y) erstreckt, die orthogonal zur Stapelrichtung (Z) ist;
ii- Herstellen einer ersten dielektrischen Schicht (3a), die auf einer ersten Seitenfläche (12a) des Zwischenbandes aufgebracht ist, und einer zweiten dielektrischen Schicht (3b), die auf einer zweiten Seitenfläche (12b) des Zwischenbandes (12i) aufgebracht ist, die der ersten Seitenfläche (12a) gegenüberliegt;
iii- Herstellen eines Führungsbandes (12) durch eine teilweise anisotrope Ätzung der Zwischenbasis in Stapelrichtung (Z) beiderseits des Zwischenbandes (12i); wobei das Führungsband (12) auf einer Basis (11) angeordnet ist, die durch die nicht geätzten Schichten des ursprünglichen Stapels gebildet wird; wobei das Führungsband (12) und die Basis (11) eine Band-Heterostruktur (1) bilden; wobei das Führungsband (12) konfiguriert ist, um eine begrenzte Lichtwelle auszubreiten
iv- Aufbringen mindestens einer elektrisch halbisolierenden Struktur (2) mittels Epitaxie, um das Führungsband (12) in der elektrisch halbisolierenden Struktur (2) zu begrenzen; wobei die erste dielektrische Schicht (3a) und die zweite dielektrische Schicht (3b) jeweils zwischen der halbleitenden Schicht (2) und dem Führungsband (12) begrenzt sind;
v- vollständiges Entfernen der dielektrischen Ätzmaske (4) durch Ätzen.

## Claims

1. Optoelectronic component (D1) comprising a stack of layers on a substrate (SUB) along a stacking direction (Z); the stack comprising:
- a ribbon heterostructure (1) comprising a base (11) and a guiding ribbon (12) extending along a guiding direction (Y) orthogonal to the stacking direction (Z), the guiding ribbon (12) being configured to propagate a confined light wave; the guiding ribbon (12) having a first lateral face (12a) and a second lateral face (12b) extending parallel to the stacking direction (Z) and to the guiding direction (Y);
- a first dielectric layer (3a) deposited on the first lateral face (12a);
- a second dielectric layer (3b) deposited on the second lateral face (12b);
- a semi-insulating structure (2) wherein the guiding ribbon (12) is buried;
the first dielectric layer (3a) and the second dielectric layer (3b) each being confined between the semi-insulating layer (2) and the guiding ribbon (12);
**characterized in that**
the thickness (e2) of the semi-insulating structure (2) is greater than or equal to the thickness (e12) of the guiding ribbon (12) along the stacking direction (Z).

2. Optoelectronic component (D1) according to claim 1 wherein the first dielectric layer (3a) and the second dielectric layer (3b) are made of a dielectric material incompatible with epitaxial deposition of the semi-insulating layer (2).

3. Optoelectronic component (D1) according to one of claims 1 or 2 wherein the first dielectric layer (3a) and the second dielectric layer (3b) are made of an amorphous dielectric material.

4. Optoelectronic component (D1) according to any one of claims 1 to 3, wherein the first dielectric layer (3a) and the second dielectric layer (3b) are made of silicon oxide SiOₓ or silicon nitride SiNₓ or silicon oxynitride SiOₓN_{y} or hydrogen-doped amorphous silicon aSi:H or a silicon and silicon nitride alloy, or aluminum oxide Al₂O₃.

5. Optoelectronic component (D1) according to one of claims 1 to 4 wherein the thickness (e3) of the first dielectric layer (3a) and the second dielectric layer (3b) is greater than or equal to 5 nm.

6. Optoelectronic component (D1) according to one of claims 1 to 5, wherein the semi-insulating structure (2) is made of a first semiconductor material doped with metallic ions.

7. Optoelectronic component (D1) according to one of claims 1 to 6, wherein the ribbon heterostructure (1) comprises:
• a lower confinement structure (11) made of a seconds semiconductor material;
• an active region (121) made of at least one third semiconductor material;
• an upper confinement structure (122) made of a fourth semiconductor material;
the active region being confined between the upper confinement structure (122) and the lower confinement structure (11); said active region being configured to absorb incident photons or generate photons by recombination of charge carriers injected into the upper confinement structure (122) and the lower confinement structure (11);
the guiding ribbon (12) being formed by at least: the upper confinement structure and the active region (121).

8. Method for manufacturing an optoelectronic component (D1, D2), comprising the following steps:
i- manufacturing an intermediate ribbon (12i) by partially etching an initial stack of semiconductor layers (11', 121', 122') deposited on a substrate (SUB); said intermediate ribbon being covered with a dielectric etching mask (4); the intermediate ribbon (12i) being arranged on an intermediate base formed by the non-etched layers of said initial stack (121', 11'); said intermediate ribbon extending along a guiding direction (Y) orthogonal to the stacking direction (Z);
ii- manufacturing a first dielectric layer (3a) deposited on a first lateral face (12a) of the intermediate ribbon and a second dielectric layer (3b) deposited on a second lateral face (12b) of the intermediate ribbon (12i), opposite said first lateral face (12a);
iii- manufacturing a guiding ribbon (12) by partially anisotropically etching the intermediate base, along the stacking direction (Z), on either side of the intermediate ribbon (12i); the guiding ribbon (12) being arranged on a base (11) formed by the non-etched layers of said initial stack; the guiding ribbon (12) and the base (11) forming a ribbon heterostructure (1); said guiding ribbon (12) being configured to propagate a confined light wave;
iv- epitaxially depositing at least one electrically semi-insulating structure (2) so as to confine the guiding ribbon (12) within said electrically semi-insulating structure (2); the first dielectric layer (3a) and the second dielectric layer (3b) each being confined between the semi-insulating layer (2) and the guiding ribbon (12);
v- completely removing the dielectric etching mask (4) by etching.
